# EUROPEAN PATENT APPLICATION

(11) **EP 2 605 286 A1**
(43) Date of publication of application: **19.06.2013**
(21) Application number: 12184143.1
(22) Date of filing: 12.09.2012
(51) Int. Cl.: H01L 31/0224, H01L 31/068

(54) **Photoelectric module**

(30) Priority: 13.12.2011 US 201161570001 P; 03.08.2012 US 201213566060
(71) Applicant: Samsung SDI Co., Ltd., Yongin-si, Gyeonggi-do (KR)
(72) Inventor: Lee, Seung-Hee, Chungcheongnam-do, 331-300 (KR); Park, Yong-Hee, Chungcheongnam-do 331-300 (KR); Yang, Jung-Yup, Gyeonggi-do (KR); Kim, Bum-Rae, Gyeonggi-do (KR); Huh, Pil-Ho, Gyeonggi-do (KR); Ahn, Young-Kyoung, Gyeonggi-do (KR); Lee, Dong-Jun, Gyeonggi-do (KR)
(74) Representative: Mounteney, Simon James

(57) **Abstract**

According to the present invention, a photoelectric module capable of reducing the number of manufacturing processes and a material cost, and of effectively preventing a short between opposite polarities is provided.

## Description

### [Technical Field]

One or more embodiments of the present invention relate to a photoelectric module.

### [Related Art]

Currently, due to problems such as exhaustion of energy resources and environmental pollution of the earth, development of clean energy sources is accelerated. As clean energy, photovoltaic energy generated using solar cells is directly transformed from sunlight and thus is regarded as a new energy source.

According to required output characteristics, solar cells may be provided in the form of a module including a plurality of cells. For example, since a plurality of cells are connected in series, a high open voltage may be provided.

### [Disclosure of the Invention]

One or more embodiments of the present invention include a photoelectric module capable of reducing the number of manufacturing processes and a material cost.

One or more embodiments of the present invention include a photoelectric module capable of preventing a short between opposite polarities.

According to one or more embodiments of the present invention, provided is a photoelectric module that includes a substrate;
a first and a second electrode; and
an insulation layer that insulates the electrodes, wherein the device only contains a single insulation layer, wherein the insulation layer comprises via holes which each contain an electrode and the electrode protrudes from a surface of the insulation layer that is furthest away from the substrate.

Preferred embodiments of the present invention are defined in the claims.

According to the present invention, by forming an insulating structure between opposite polarities as a single layer, material cost may be reduced and the number of processes required can be reduced in comparison to a multilayer insulating structure in which a series of processes such as paste printing, patterning, low-temperature curing, and high-temperature curing are repeated to form each insulating layer.

In addition to the reduced cost and the number of processes due to the single layer insulating structure, by improving a structure for bonding a conductive connection layer between a photoelectric cell and a wiring board, a short between first and second electrodes caused by an excessive fluidity of the conductive connection layer may be effectively prevented.

### [Brief Description of the Drawings]

FIG. 1 is a perspective view of a photoelectric module according to an embodiment of the present invention.
FIG. 2 is a cross-sectional view cut along a line II-II illustrated in FIG. 1.
FIG. 3 is a magnified cross-sectional view of a portion of FIG. 2.
FIGS. 4A through 4D are cross-sectional views for describing a method of manufacturing a photoelectric module according to a comparative example.
FIGS. 5A through 5L are cross-sectional views for describing a method of manufacturing a photoelectric module according to an embodiment of the present invention.
FIG. 6 is a plan view showing the structure of first and second electrodes.
FIGS. 7A and 7B are plan views of a photoelectric module according to another embodiment of the present invention, where FIG. 7A is a plan view of an array of photoelectric cells, and FIG. 7B is a plan view of a wiring board bonded to the array of photoelectric cells illustrated in FIG. 7A.

### [Detailed Description]

The present invention provides a photovoltaic device comprising:
a substrate;
a first and a second electrode; and an insulation layer that insulates the electrodes, wherein the device only contains a single insulation layer, wherein the insulation layer comprises via holes which each contain an electrode and the electrode protrudes from a surface of the insulation layer that is furthest away from the substrate.

In an embodiment of the present invention the photovoltaic device further comprises a passivation layer formed between the substrate and the single insulation layer.

In an embodiment of the present invention the electrodes each comprise a seed layer, wherein the seed layer is equal to or less thick than the single insulation layer.

In an embodiment of the present invention the electrodes comprise seed layers of thickness (d1) and conductive layers of thickness (d2+t3)

In an embodiment of the present invention the electrodes each comprise a seed layer, wherein a surface of the seed layer that is furthest away from the substrate is lower than the surface of the single insulation layer that is furthest away from the substrate.

In an embodiment of the present invention the electrodes also comprise a conductive connective layer and, optionally the combined thicknesses of the seed layer (d1) and of the conductive layer are greater than by a value t3 of the thickness of single insulation layer and the passivation layer, if present.

In an embodiment of the present invention d1 is between 40% and 60% of the thickness of the single insulation layer (t2).

In an embodiment of the present invention the insulation layer has a thickness of between 10µm and 30µm.

In an embodiment of the present invention the conductive layer comprises first and second portions of differing widths.

In an embodiment of the present invention the first portion of the conductive layer is formed on the seed layer and is narrower in width than the second portion.

In an embodiment of the present invention the wherein the first portion is of depth d2 and the second portion is of depth t3.

In an embodiment of the present invention the passivation layer and the insulation layer comprise different materials, optionally wherein the insulation layer comprises a thermosetting resin.

In an embodiment of the present invention the passivation layer comprises a silicon nitride, a silicon oxide or a combination thereof.

In an embodiment of the present invention the conductive connection layer is made of a solder material.

In an embodiment of the present invention the device comprises an array of photoelectric cells and the device further comprises a wiring board wherein the array of photoelectric cells are conductively connected by the wiring board.

The present invention also provides a process for preparing any of the devices described above, which comprises the steps of:
forming a single insulation layer comprising via holes on a substrate,
forming electrodes in said via holes.

In an embodiment of the present invention the electrodes are formed by first forming a seed layer in the via holes.

In an embodiment of the present invention the conductive connective layer is formed on the seed layer and the conductive connective layer protrudes out of the single insulator layer.

Reference will now be made in detail to embodiments, examples of which are illustrated in the accompanying drawings, wherein like reference numerals refer to the like elements throughout. The reference numbers are only included as a means of identifying a feature in a figure. The features of the present invention are not limited to the specific embodiments disclosed in the figures.

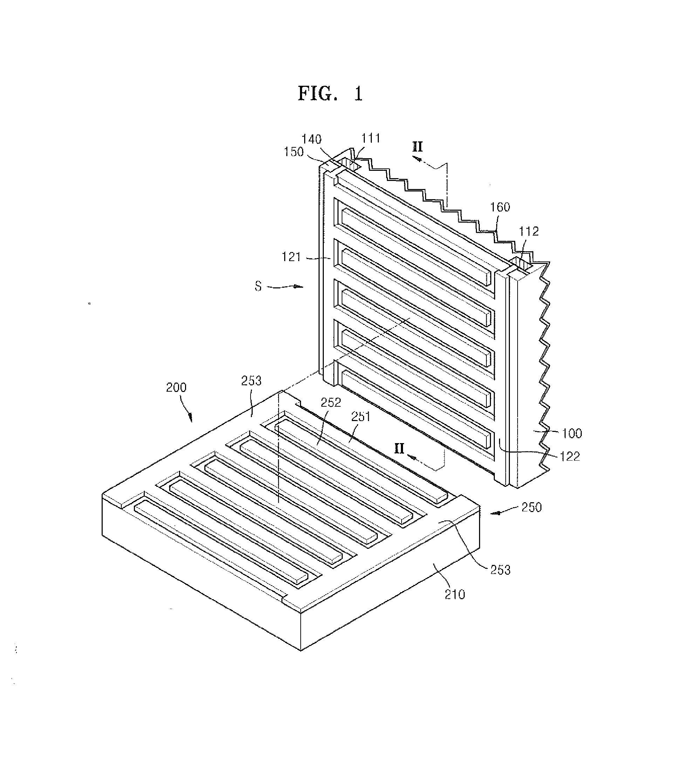

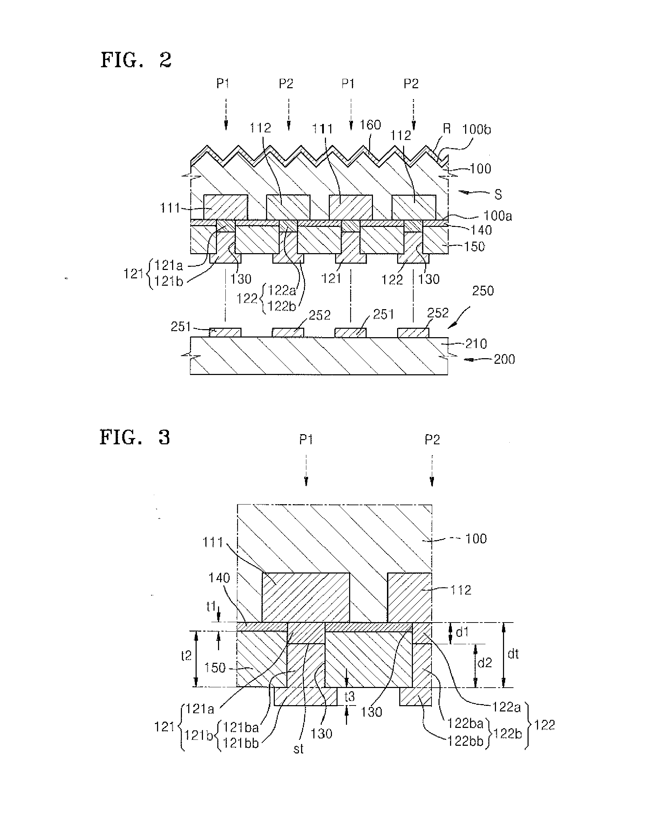

FIG. 1 is a perspective view of a photoelectric module according to an embodiment of the present invention. FIG. 2 is a cross-sectional view cut along a line II-II illustrated in FIG. 1. Referring to FIGS. 1 and 2, the photoelectric module includes a wiring board 200, and a photoelectric cell S facing and electrically connected onto the wiring board 200.

Referring to FIG. 2, the photoelectric cell S includes a semiconductor substrate 100, first and second semiconductor layers 111 and 112 alternately formed in the semiconductor substrate 100, and first and second electrodes 121 and 122 respectively connected to the first and second semiconductor layers 111 and 112.

In an embodiment of the present invention, the semiconductor substrate 100 has a first surface 100a, and a second surface 100b opposite to the first surface 100a. For example, back-contact may be formed by forming both of emitter and base electrodes (the first and second electrodes 121 and 122) on the first surface 100a of the semiconductor substrate 100 and using the second surface 100b excluding the electrode structure as a light-receiving surface, such that valid incident light may be increased and an optical loss may be reduced. In more detail, since back-contact is formed by not forming electrodes on a light-receiving surface of the semiconductor substrate 100, an optical loss due to the electrode may be reduced and a high output may be obtained in comparison to a solar cell structure in which electrodes are formed on a light-receiving surface.

For example, the semiconductor substrate 100 may generate photo-generated carriers by receiving light on the second surface 100b. The photo-generated carriers refer to holes and electrons generated due to light absorbed into the semiconductor substrate 100.

In a preferred embodiment of the present invention the semiconductor substrate 100 is formed as a monocrystalline or polycrystalline silicon (Si) substrate having an n or p conductive type. For example, according to an embodiment of the present invention, the semiconductor substrate 100 may be formed as an n-type monocrystalline Si substrate.

In a preferred embodiment of the present invention a texture structure R including an uneven pattern is formed on the second surface 100b of the semiconductor substrate 100. The texture structure R may reduce the reflectivity of incident light and may form an uneven surface including a plurality of minute bumps.

In a preferred embodiment of the present invention an antireflective film 160 is formed on the second surface 100b of the semiconductor substrate 100. The antireflective film 160 preferably is formed from a silicon nitride (SiNx) or silicon oxide (SiOx) film. For example, the antireflective film 160 may be formed as a single layer of a SiNx or SiOx film, or a multilayer of SiNx and SiOx films having different refractive indices. Such silicon nitride and silicon oxide films are known in the art.

The antireflective film 160 may prevent surface recombination of the carriers generated by the semiconductor substrate 100 and thus may improve a carrier collecting efficiency. For example, the antireflective film 160 may reduce a surface recombination loss due to a surface defect of the semiconductor substrate 100 and may improve a carrier collecting efficiency.

According to another preferred embodiment of the present invention, in addition to the antireflective film 160, a passivation film (not shown) is further formed on the second surface 100b of the semiconductor substrate 100. The passivation film is preferably formed as an intrinsic semiconductor layer, a doped semiconductor layer, a SiNx film, or a SiOx film. The intrinsic or doped semiconductor layer is preferably formed by vapor-depositing amorphous silicon (a-Si) on the semiconductor substrate 100. For example, the passivation film may have the same conductive type as the semiconductor substrate 100 and may be doped at a higher concentration than the semiconductor substrate 100, thereby forming a surface electric field.

The first and second semiconductor layers 111 and 112 having opposite conductive types are preferably formed in the first surface 100a of the semiconductor substrate 100. The first and second semiconductor layers 111 and 112 may form an emitter and a base for separately collecting the carriers generated by the semiconductor substrate 100.

The first semiconductor layers 111 are preferably formed by diffusing a p-type or n-type dopant into the semiconductor substrate 100. For example, the first semiconductor layers 111 may be doped in an opposite conductive type (i.e., a p type) to the n-type semiconductor substrate 100 and may form an emitter for collecting minor carriers (e.g., holes) from the n-type semiconductor substrate 100.

The second semiconductor layers 112 are preferably formed by diffusing a p-type or n-type dopant into the semiconductor substrate 100. For example, the second semiconductor layers 112 may be doped in the same conductive type (i.e., an n type) to the n-type semiconductor substrate 100 and may form a base for collecting major carriers (e.g., electrons) from the n-type semiconductor substrate 100.

A passivation film 140 is preferably formed on the first surface 100a of the semiconductor substrate 100. The passivation film 140 may prevent surface recombination of the carriers generated by the semiconductor substrate 100 and thus may improve a carrier collecting efficiency. For example, the passivation film 140 may reduce a surface recombination loss due to a surface defect of the semiconductor substrate 100 and may improve a carrier collecting efficiency. For example, the passivation film 140 may be formed as a SiNx or SiOx film.

In a preferred embodiment of the present invention an insulating layer 150 is formed on the passivation film 140. The insulating layer 150 may prevent an electrical short between the first and second electrodes 121 and 122 having opposite conductive types and may insulate the first and second electrodes 121 and 122 from each other.

In a preferred embodiment of the present invention the insulating layer 150 is pattern-printed by performing, for example, screen printing or inkjet printing so as to open via holes 130 for electrode connection. For example, the insulating layer 150 may be formed of a thermosetting resin having a variable fluidity according to a temperature variation and cured at a high temperature, e.g., polyamide or polyimide. In a preferred embodiment of the present invention the insulating layer 150 is fixed onto the passivation film 140 by performing primary curing at about 100°C to about 150°C and secondary curing at a high temperature equal to or greater than about 300°C, preferably between 300°C and 500°C.

In a preferred embodiment of the present invention the insulating layer does not have an adhesive function, i.e. the insulating layer does not adhere to layers or substrates on the opposite face to the passivation layer.

FIG. 3 is a magnified cross-sectional view of a portion of FIG. 2.

In a preferred embodiment of the present invention the first and second electrodes 121 and 122 are respectively electrically connected to the first and second semiconductor layers 111 and 112 of the semiconductor substrate 100 through the via holes 130 that penetrate from the surface of the insulating layer 150 to the semiconductor substrate 100. For example, the via holes 130 may be formed along a thickness direction of the insulating layer 150 and the passivation film 140.

The insulating layer 150 is formed as a single layer and, in an embodiment of the present invention a total depth dt of the via holes 130 may equal to a sum of a thickness t1 of the passivation film 140 and a thickness t2 of the insulating layer 150 (that is, dt = t1 + t2). Since the single insulating layer 150 may ensure electrical insulation between the first and second electrodes 121 and 122 and may prevent a short between positive and negative electrodes, in comparison to a structure including a multilayer insulating layer, a material cost for the insulating layer 150 may be reduced and a series of processes for forming the insulating layer 150, e.g., printing, patterning, and curing, may be greatly reduced.

In an embodiment of the present invention the via holes 130 expose the first and second semiconductor layers 111 and 112 and connect the first and second semiconductor layers 111 and 112 respectively to the first and second electrodes 121 and 122. For example, the via holes 130 may be formed in a plural number corresponding to the first and second semiconductor layers 111 and 112 alternately arranged on the semiconductor substrate 100.

In more detail, in a preferred embodiment of the present invention, the first and second electrodes 121 and 122 respectively include seed layers 121a and 122a formed to fill a first depth d1 of the via holes 130, and conductive connection layers 121b and 122b formed to fill a second depth d2 of the via holes 130. Here, the first and second depths d1 and d2 of the via holes 130 are parts of the total depth dt of the via holes 130. For example, a sum of the first and second depths d1 and d2 may equal to the total depth dt of the via holes 130 (that is, dt = d1 + d2). In a preferred embodiment of the present invention, the conductive connection layers 121b and 122b fill the second depth d2 of the via holes 130 and then may extend to protrude from the surface of the insulating layer 150 to a predetermined thickness t3.

In a preferred embodiment of the present invention, the seed layers 121a and 122a fill the first depth d1 of the via holes 130 and are formed in the via holes 130. As such, the seed layers 121a and 122a may not protrude from the surface of the insulating layer 150 and may have a surface st stepped and recessed into the insulating layer 150. That is, the surface st of the seed layers 121a and 122a may form steps recessed from the surface of the insulating layer 150.

For example, a thickness of the seed layers 121a and 122a, i.e., the first depth d1 of the via holes 130 filled with the seed layers 121a and 122a, is preferably between 40% and 60% of the thickness of the single insulation layer (t2), more preferably about 1/2 of the thickness t2 of the insulating layer 150. In a preferred embodiment of the present invention the insulation layer has a thickness of between 10µm and 30µm, 15µm and 25µm or 17µm and 22µm. For example, if the insulating layer 150 has a thickness of about 20µm, the seed layers 121a and 122a may have a thickness of about 10µm.

The seed layers 121a and 122a are preferably formed as under layers for forming the conductive connection layers 121b and 122b. The seed layers 121a and 122a are preferably formed by performing sputtering or plating such as electroplating or light induced plating (LIP). For example, the seed layers 121a and 122a may be formed to an initial thickness by performing sputtering and then may be precisely formed to an ultimate thickness by performing plating such as electroplating or LIP.

Since base layers for a subsequent plating process may preferably be formed to an initial thickness by performing sputtering, and then an ultimate thickness of the seed layers 121a and 122a may be precisely controlled by performing plating, the seed layers 121a and 122a may fill only a partial depth, i.e., the first depth d1, of the via holes 130 without filling the remaining second depth d2. Thus, the second depth d2 of the via holes 130 may define first and second electrode positions P1 and P2 for the conductive connection layers 121b and 122b, and a short between positive and negative electrodes caused when the conductive connection layers 121b and 122b melt and flow away from the first and second electrode positions P1 and P2 toward the second and first electrode positions P2 and P1 corresponding to opposite polarities may be prevented.

The conductive connection layers 121b and 122b are preferably formed on the seed layers 121a and 122a. The conductive connection layers 121b and 122b are preferably formed on the surface st of the seed layers 121a and 122a in the via holes 130. The conductive connection layers 121b and 122b may fill the second depth d2 of the via holes 130 and then may protrude from the surface of the insulating layer 150 to the predetermined thickness t3. That is, the conductive connection layers 121b and 122b may protrude downward from the insulating layer 150. Due to the protruding portions of the conductive connection layers 121b and 122b, the photoelectric cell S and the wiring board 200 may be electrically connected.

Since in an embodiment of the present invention the conductive connection layers 121b and 122b fill the second depth d2 of the recessed via holes 130, a short between the first and second electrodes 121 and 122 due to the flow of the conductive connection layers 121b and 122b may be prevented. A detailed description thereof will now be provided.

That is, the conductive connection layers 121b and 122b may be bonded between and may electrically connect the photoelectric cell S and the wiring board 200. For example, the photoelectric cell S on which the conductive connection layers 121b and 122b are formed may be aligned on the wiring board 200, and the conductive connection layers 121b and 122b may be bonded between the photoelectric cell S and the wiring board 200 by performing reflow soldering at a high temperature, thereby electrically connecting the photoelectric cell S and the wiring board 200 to each other.

In this case, when the conductive connection layers 121b and 122b are heated to a melted or semi-melted state and form firmly conductive coupling between the photoelectric cell S and the wiring board 200, if the conductive connection layers 121b and 122b having fluidity flow away from their right positions toward other positions, a short may occur between the first and second electrodes 121 and 122.

According to an embodiment of the present invention, since the conductive connection layers 121b and 122b fill the second depth d2 of the recessed via holes 130, the melted conductive connection layers 121b and 122b may be centered on the via holes 130 and right positions of the conductive connection layers 121b and 122b may be defined by the via holes 130. Consequently, a short caused when the conductive connection layer 121b flows away from its right position, i.e., the first electrode position P1, toward the second electrode position P2, or when the conductive connection layer 122b flows away from its right position, i.e., the second electrode position P2, toward the first electrode position P1 due to an excessive fluidity may be prevented.

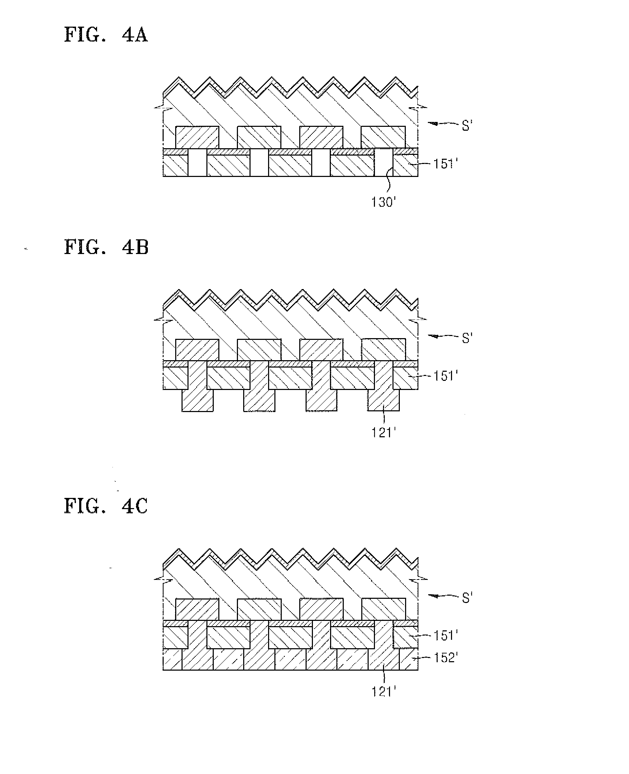

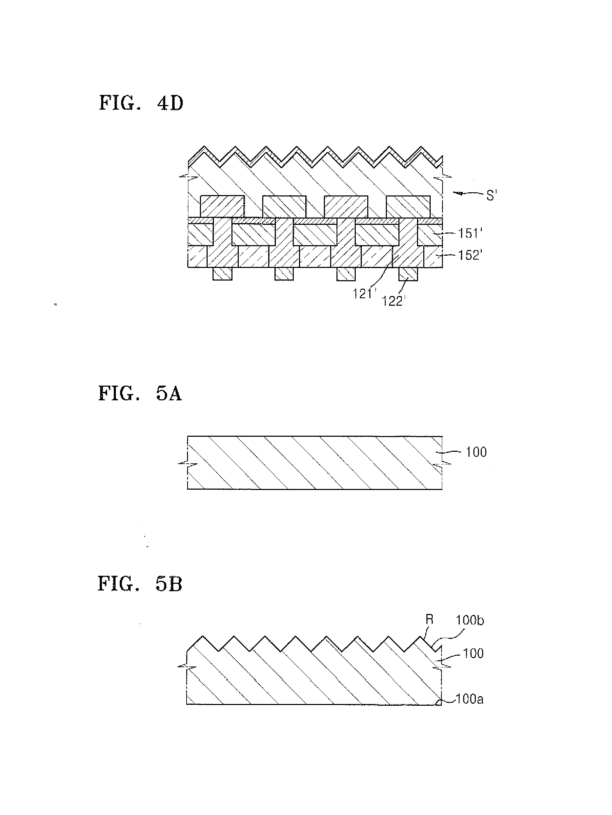

FIGS. 4A through 4D are cross-sectional views for describing a method of manufacturing a photoelectric cell S' according to a comparative example. Referring to FIG. 4A, a first insulating layer 151' is formed on one surface of the photoelectric cell S', and via holes 130' for electrode connection are formed in the first insulating layer 151'. Then, as illustrated in FIG. 4B, first electrode layers 121' fill the via holes 130'. If the photoelectric cell S' is assembled on a wiring board in this state, a short may easily occur due to fluidity of the first electrode layers 121'. Thus, a second insulating layer 152' is filled between the first electrode layers 121' as illustrated in FIG. 4C, second electrode layers 122' having a width less than that of the first electrode layers 121' are formed as illustrated in FIG. 4D, and then the photoelectric cell S' is assembled on the wiring board.

In the comparative example, since a multilayer insulating layer including the first and second insulating layers 151' and 152' is formed as an insulating layer for preventing a short between positive and negative electrodes, a material cost for the insulating layer having a relatively high price is wasted and processes are repeated to form each of the first and second insulating layers 151' and 152'. That is, a series of processes such as paste printing, precise patterning, low-temperature curing, and high-temperature curing are repeated to form each of the first and second insulating layers 151' and 152'.

Also, since the second electrode layers 122' for connecting the photoelectric cell S' and the wiring board are formed on a relatively flat surface, the flow of the second electrode layers 122' may not be easily blocked, the melted second electrode layers 122' may freely flow away from their right positions, and thus a short may probably occur between positive and negative electrodes of the photoelectric cell S'.

When compared to the comparative example, according to an embodiment of the present invention, for example that displayed in FIG. 3, since the single insulating layer 150 is used, a material cost for the insulating layer 150 may be reduced and a series of processes for forming the insulating layer 150, e.g., printing, patterning, and curing, may be greatly reduced.

Also, since the conductive connection layers 121b and 122b for connecting the photoelectric cell S and the wiring board 200 fill the second depth d2 of the recessed via holes 130, the flow of the conductive connection layers 121b and 122b may be effectively blocked and a short between positive and negative electrodes of the photoelectric cell S may be prevented.

When the single insulating layer 150 is formed, since an electrode structure, i.e., the seed layers 121a and 122a and portions of the conductive connection layers 121b and 122b, is preferably formed in the via holes 130, a total thickness of the photoelectric cell S may be reduced and a thin photoelectric cell S may be provided.

In a preferred embodiment of the present invention, the conductive connection layers 121b and 122b preferably respectively include first and second portions 121ba and 121bb, and 122ba, and 122bb having different widths and, for example, may be formed in a rivet shape. The first portions 121ba and 122ba may fill the second depth d2 of the via holes 130 and may be formed in the via holes 130 to have a relatively small width. The second portions 121bb and 122bb may protrude from the surface of the insulating layer 150 to the predetermined thickness t3 and may be formed to have a relatively large width so as to cover portions of the surface of the insulating layer 150. Since the second portions 121bb and 122bb of the conductive connection layers 121b and 122b facing the wiring board 200 are formed to have a relatively large width, a connection resistance against the wiring board 200 may be reduced.

In a preferred embodiment of the present invention the conductive connection layers 121b and 122b may be formed by using, for example, soldering, solder paste, or solder balls, and may be formed of a conductive material having electrical conductivity, bondable between the photoelectric cell S and the wiring board 200, and having a low melting point.

In a preferred embodiment of the present invention the seed layers 121a and 122a are preferably formed from a conductive material, such as copper (Cu), gold (Au), silver (Ag), or aluminum (Al), preferably Ag.

Referring to back FIG. 2, in a preferred embodiment of the present invention the photoelectric cell S faces, is bonded onto, and is electrically connected onto the wiring board 200. The wiring board 200 includes an insulating substrate 210, and a conductive pattern 250 formed on the insulating substrate 210.

The insulating substrate 210 is preferably formed of an insulating material having an electrical resistance higher than that of the conductive pattern 250, e.g., polyethylene naphthalate (PEN) or polyethylene terephthalate (PET).

The conductive pattern 250 electrically connected to the first and second electrodes 121 and 122 of the photoelectric cell S may be formed on the insulating substrate 210, and more particularly, on one surface of the insulating substrate 210 facing the photoelectric cell S. The conductive pattern 250 is used to extract electric power generated by the photoelectric cell S. The conductive pattern 250 may include first and second conductive patterns 251 and 252 respectively electrically connected to the first and second electrodes 121 and 122 of the photoelectric cell S.

The first conductive patterns 251 are electrically connected to the first electrodes 121 of the photoelectric cell S, and the second conductive patterns 252 are electrically connected to the second electrodes 122 of the photoelectric cell S. With respect to relative positions of the first and second conductive patterns 251 and 252, for example, when the first conductive patterns 251 are electrically connected to the first electrodes 121 of the photoelectric cell S, the second conductive patterns 252 may overlap the second electrodes 122 of the photoelectric cell S. Likewise, when the second conductive patterns 252 are electrically connected to the second electrodes 122 of the photoelectric cell S, the first conductive patterns 251 may overlap the first electrodes 121 of the photoelectric cell S.

The first and second conductive patterns 251 and 252 of the wiring board 200 may be respectively electrically connected to the first and second electrodes 121 and 122 of the photoelectric cell S by aligning the photoelectric cell S, in which the conductive connection layers 121b and 122b are formed, on the wiring board 200, and performing reflow soldering at a high temperature to bond the conductive connection layers 121b and 122b between the photoelectric cell S and the wiring board 200, thereby electrically connecting the wiring board 200 and the photoelectric cell S.

The conductive pattern 250 may be formed of a conductive material having an electrical resistance lower than that of the insulating substrate 210, e.g., a metallic material such as copper (Cu), gold (Au), silver (Ag), or aluminum (Al). For example, the conductive pattern 250 may be formed by forming a conductive layer (not shown) such as thin Cu film on the insulating substrate 210, forming a resist pattern (not shown) on the conductive layer, and etching predetermined portions of the conductive layer.

FIGS. 5A through 5L are cross-sectional views for describing a method of manufacturing a photoelectric module according to an embodiment of the present invention.

Initially, as illustrated in FIG. 5A, the semiconductor substrate 100 is prepared. For example, the semiconductor substrate 100 is preferably prepared as an n-type crystalline Si wafer.

Then, as illustrated in FIG. 5B, the second surface 100b of the semiconductor substrate 100 is preferably textured. For example, an etching mask (not shown) may be formed on the first surface 100a of the semiconductor substrate 100, and the second surface 100b of the semiconductor substrate 100 may be etched. In a preferred embodiment, the texture structure R having an uneven pattern may be formed in the second surface 100b of the semiconductor substrate 100 by anisotropically etching the semiconductor substrate 100 by using an alkaline solution such as KOH or NaOH.

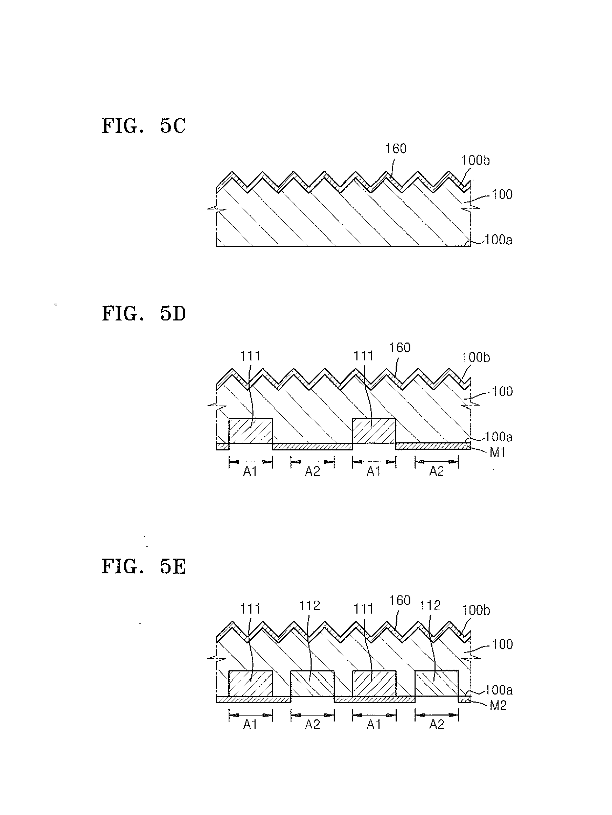

Then, as illustrated in FIG. 5C, the antireflective film 160 is preferably formed on the second surface 100b of the semiconductor substrate 100. The antireflective film 160 may be formed as a SiOx or SiNx film. For example, the antireflective film 160 may be formed as a single layer of a SiOx or SiNx film, or a multi layer of SiOx and SiNx films having different refractive indices. The antireflective film 160 may be formed by performing thermal oxidation or chemical vapor deposition (CVD).

Then, as illustrated in FIG. 5D, the first diffusion mask M1 is preferably formed on the first surface 100a of the semiconductor substrate 100. In this case, the first diffusion mask M1 may define first semiconductor regions A1 and may have a pattern of openings corresponding to the first semiconductor regions A1. After that, the first semiconductor layers 111 are formed by diffusing a first conductive type dopant into the first semiconductor regions A1 exposed by the first diffusion mask M1. For example, BBr₃ may be injected as a doping source via a carrier gas onto the semiconductor substrate 100 in a diffusion tube (not shown), and a p-type dopant (boron (B)) may be diffused into the exposed first semiconductor regions A1. Then, the first diffusion mask M1 that is out of use and a glass layer (a borosilicate glass (BSG) layer; not shown) that is additionally formed during the dopant diffusing process may be removed.

Then, as illustrated in FIG. 5E, the second diffusion mask M2 is preferably formed on the first surface 100a of the semiconductor substrate 100. In this case, the second diffusion mask M2 may define second semiconductor regions A2 and may have a pattern of openings corresponding to the second semiconductor regions A2. After that, the second semiconductor layers 112 are formed by diffusing a second conductive type dopant into the second semiconductor regions A2 exposed by the second diffusion mask M2. For example, POCl₃ may be injected as a doping source via a carrier gas onto the semiconductor substrate 100 in a diffusion tube (not shown), and an n-type dopant (phosphorus (P)) may be diffused into the exposed second semiconductor regions A2. Then, the second diffusion mask M2 that is out of use and a glass layer (a phosphosilicate glass (PSG) layer; not shown) that is additionally formed during the dopant diffusing process may be removed.

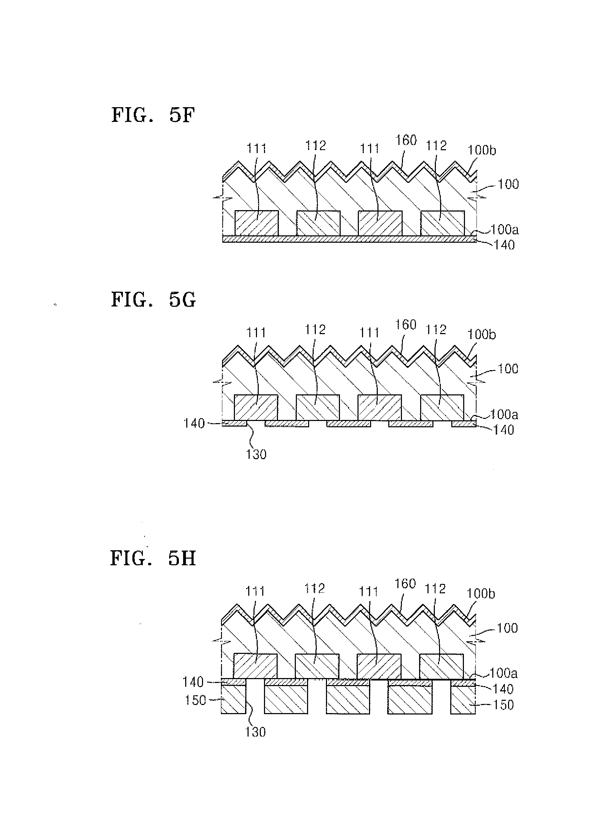

Then, as illustrated in FIG. 5F, the passivation film 140 is preferably formed on the first surface 100a of the semiconductor substrate 100. For example, the passivation film 140 may be formed as a SiOx or SiNx film by performing thermal oxidation or CVD.

Then, as illustrated in FIG. 5G, the via holes 130 are preferably formed in the passivation film 140. The via holes 130 for electrode connection are formed by removing portions of the passivation film 140 covering the first and second semiconductor layers 111 and 112. For example, the via holes 130 may be formed in a plural number corresponding to the first and second semiconductor layers 111 and 112 alternately arranged on the semiconductor substrate 100. For example, the via holes 130 may be formed by using etching paste.

Then, as illustrated in FIG. 5H, the insulating layer 150 is preferably formed on the passivation film 140. The insulating layer 150 may be pattern-printed by performing, for example, screen printing or inkjet printing so as to open the via holes 130 for electrode connection. For example, the insulating layer 150 may be formed of a thermosetting resin having a variable fluidity according to a temperature variation and cured at a high temperature, e.g., polyamide or polyimide. The insulating layer 150 may be fixed onto the passivation film 140 by performing primary curing at about 100°C to about 150°C and secondary curing at a high temperature equal to or greater than about 300°C, preferably between 300°C and 500°C.

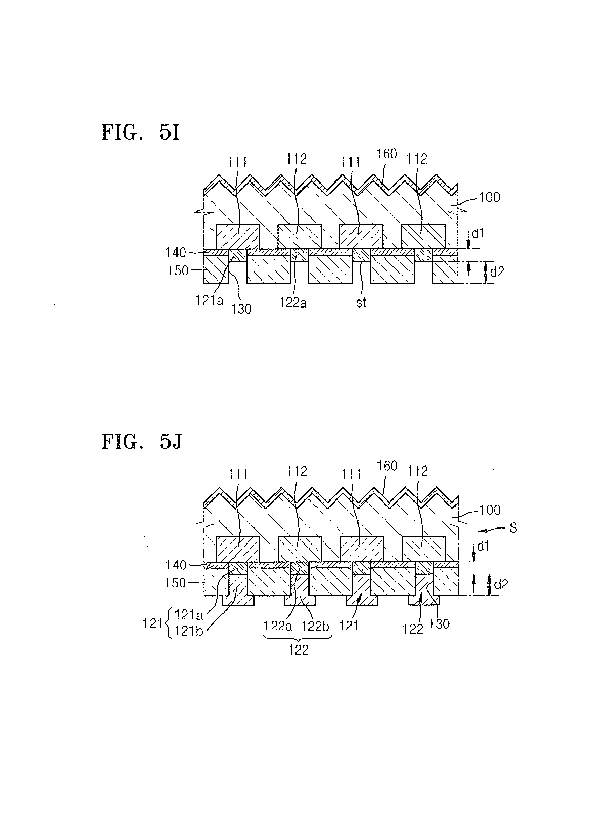

Then, as illustrated in FIG. 5I, the seed layers 121a and 122a are preferably formed in the via holes 130. The seed layers 121a and 122a fill the first depth d1 of the via holes 130 and have the surface st stepped and recessed from the surface of the insulating layer 150 by the remaining second depth d2 of the via holes 130.

The seed layers 121a and 122a may be formed by performing sputtering or plating such as electroplating or LIP. For example, the seed layers 121a and 122a may be formed to an initial thickness by performing sputtering and then may be precisely formed to an ultimate thickness by performing plating such as electroplating or LIP.

Then, as illustrated in FIG. 5J, the conductive connection layers 121b and 122b are preferably formed on the seed layers 121a and 122a. The conductive connection layers 121b and 122b may be formed of a conductive material having electrical conductivity, bondable between the photoelectric cell S and the wiring board 200, and having a low melting point. For example, the conductive connection layers 121b and 122b may be pattern-printed by performing screen printing or inkjet printing and by using soldering, solder paste, or solder balls.

For example, the conductive connection layers 121b and 122b may fill the second depth d2 of the via holes 130 and may protrude from the surface of the insulating layer 150. However, since the conductive connection layers 121b and 122b have fluidity when being heated to a melted or semi-melted state in a bonding process to be described below, an ultimate form of the conductive connection layers 121b and 122b formed to fill the second depth d2 of the via holes 130 may be achieved in the bond process.

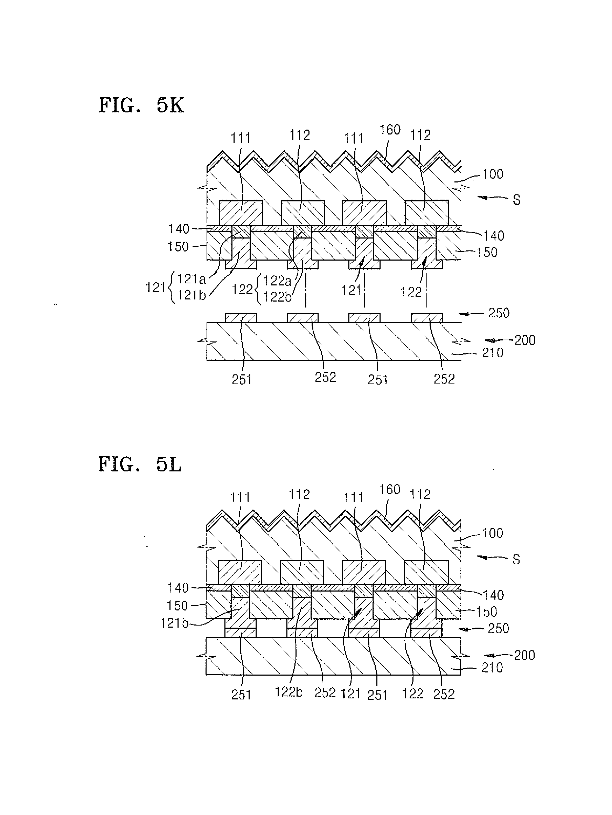

As illustrated in FIG. 5K, the photoelectric cell S formed as described above is connected onto the wiring board 200. The wiring board 200 connected to the photoelectric cell S may be manufactured and provided separately from the photoelectric cell S. The wiring board 200 may include the insulating substrate 210, and the conductive pattern 250 formed on the insulating substrate 210.

For example, the wiring board 200 on which the first and second conductive patterns 251 and 252 are formed may be obtained by forming a thin metal film such as a thin Cu, Au, Ag, or Al film on the insulating substrate 210 including an insulating material such as PEN or PET, forming a resist pattern (not shown) on the thin metal film, and etching predetermined portions of the thin metal film.

If the wiring board 200 is prepared, the photoelectric cell S is aligned on the wiring board 200. For example, alignment marks (not shown) may be formed on the wiring board 200 and the photoelectric cell S, and the first and second electrodes 121 and 122 of the photoelectric cell S and the first and second conductive patterns 251 and 252 of the wiring board 200 may be correctly aligned by using the alignment marks.

Then, as illustrated in FIG. 5L, the photoelectric cell S and the wiring board 200 are bonded to each other. For example, the bonding may be performed by using reflow soldering, and the photoelectric cell S and the wiring board 200 may be electrifiably bonded to each other by heating the conductive connection layers 121b and 122b to a melted or semi-melted state between the photoelectric cell S and the wiring board 200 in a furnace (not shown).

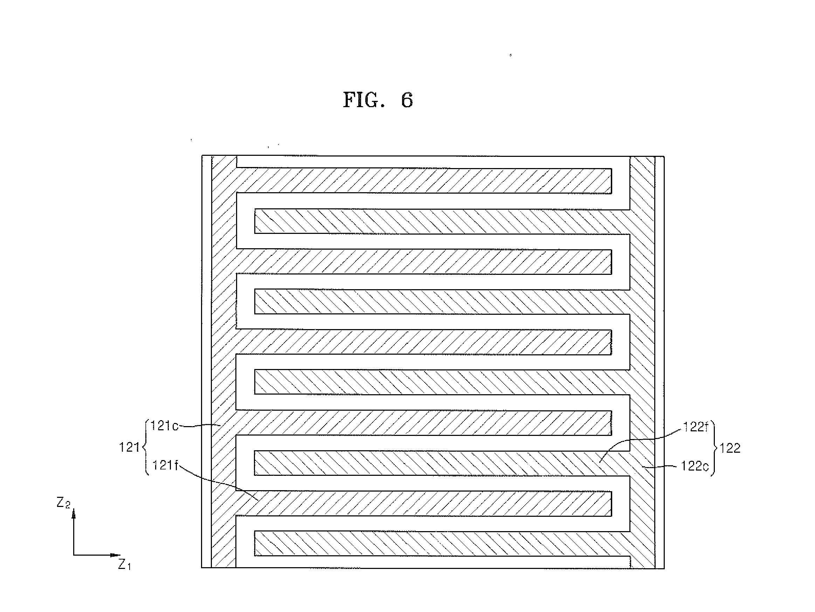

FIG. 6 is a plan view showing the structure of the first and second electrodes 121 and 122 of the photoelectric cell S in an embodiment of the present invention. Referring to FIG. 6, the first and second electrodes 121 and 122 may be formed in a shape of combs that engage with each other.

The first electrodes 121 preferably include a plurality of first finger electrodes 121f extending along one direction (Z1), and a first collection electrode 121c extending along a direction (Z2) to cross end portions of the first finger electrodes 121f, and for connecting the first finger electrodes 121f. For example, the first finger electrodes 121f may be formed in a stripe pattern along one direction (Z1), and the first collection electrode 121c may extend along a direction (Z2) almost perpendicular to the first finger electrodes 121f.

The second electrodes 122 preferably include a plurality of second finger electrodes 122f extending along one direction (Z1), and a second collection electrode 122c extending along a direction (Z2) to cross end portions of the second finger electrodes 122f, and for connecting the second finger electrodes 122f. For example, the second finger electrodes 122f may be formed in a stripe pattern along one direction (Z1), and the second collection electrode 122c may extend along a direction (Z2) almost perpendicular to the second finger electrodes 122f.

The first and second finger electrodes 121f and 122f may extend along directions to face each other and may be engaged with each other in alternate patterns. For example, the first and second semiconductor layers 111 and 112 are formed in the semiconductor substrate 100 contacting the first and second finger electrodes 121f and 122f (see FIGS. 1 and 2). The first and second electrodes 121 and 122 are not limited to the above-described shape, arrangement, and number, and may be variously modified.

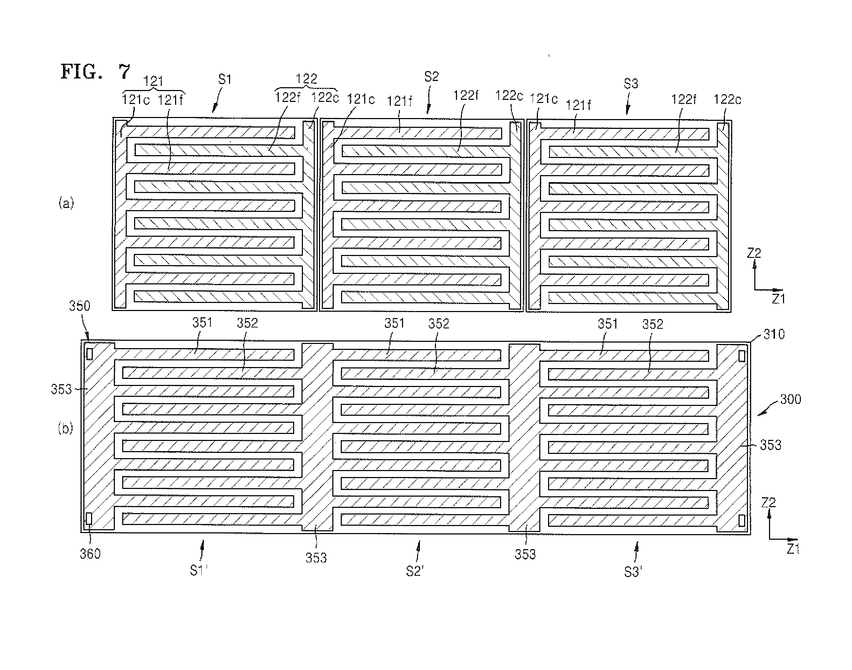

FIGS. 7A and 7B are plan views of a photoelectric module according to another embodiment of the present invention. FIG. 7A shows an array of first through third photoelectric cells S1 through S3 for forming the photoelectric module. Each of the first through third photoelectric cells S1 through S3 may have the structure illustrated in FIGS. 2 and 3, and the first and second electrodes 121 and 122 respectively including the first and second finger electrodes 121f and 122f and the first and second collection electrodes 121c and 122c may be formed on each of the first through third photoelectric cells S1 through S3.

FIG. 7B shows a wiring board 300 bonded to the first through third photoelectric cells S1 through S3 illustrated in FIG. 7A. That is, the first through third photoelectric cells S1 through S3 may be aligned in the form of an array on one wiring board 300, and may be electrically connected to each other via the wiring board 300, thereby forming the photoelectric module.

For example, the first through third photoelectric cells S1 through S3 may be respectively disposed at first through third cell positions S1' through S3'on the wiring board 300. The first through third photoelectric cells S1 through S3 are not limited to the arrangement and number illustrated in FIGS. 7A and 7B, and may be variously modified. For example, the first through third photoelectric cells S1 through S3 may be arranged in row and column directions on a two-dimensional plane of the wiring board 300.

The wiring board 300 includes an insulating substrate 310, and conductive patterns 350 formed on the insulating substrate 310. The conductive patterns 350 may include first and second conductive patterns 351 and 352 formed at each of the first through third cell positions S1' through S3' and electrically connected to the first and second electrodes 121 and 122 of the first through third photoelectric cells S1 through S3, and may further include connection patterns 353 for electrically connecting neighboring first through third photoelectric cells S1 through S3.

For example, the first conductive patterns 351 may be formed to correspond to the first electrodes 121 of the first through third photoelectric cells S1 through S3. The first conductive patterns 351 may be formed in a stripe pattern extending along one direction (Z1) so as to correspond to the first finger electrodes 121f of the first electrodes 121.

The second conductive patterns 352 may be formed to correspond to the second electrodes 122 of the first through third photoelectric cells S1 through S3. The second conductive patterns 352 may be formed in a stripe pattern extending along one direction (Z1) so as to correspond to the second finger electrodes 122f of the second electrodes 122. For example, the first and second conductive patterns 351 and 352 may be engaged with each other in alternate patterns.

The connection patterns 353 may be formed between neighboring first through third cell positions S1' through S3' and may connect neighboring first and second conductive patterns 351 and 352 to each other. For example, the connection patterns 353 may connect neighboring first through third photoelectric cells S1 through S3 in series by electrically connecting the first and second conductive patterns 351 and 352 between neighboring first through third cell positions S1' through S3', i.e., by connecting the first and second conductive patterns 351 and 352 having opposite conductive types.

For example, the connection patterns 353 may be integrally formed with the first and second conductive patterns 351 and 352. The connection patterns 353 may extend along one direction (Z2) in a line, and the first and second conductive patterns 351 and 352 having opposite conductive types may extend along two opposite directions (±Z1) perpendicular to the connection patterns 353.

The connection patterns 353 may overlap and may be electrically connected to the first and second collection electrodes 121c and 122c of the first through third photoelectric cells S1 through S3. For example, the first and second conductive patterns 351 and 352 may be respectively electrically connected to the first and second finger electrodes 121f and 122f of the first through third photoelectric cells S1 through S3, and the connection patterns 353 may overlap the first and second collection electrodes 121c and 122c of the first through third photoelectric cells S1 through S3. For example, the connection patterns 353 may be electrically connected to the first and second collection electrodes 121c and 122c of the first and second electrodes 121 and 122 at two ends of each of the first through third cell positions S1' through S3'.

Meanwhile, each of the connection patterns 353 formed at two ends of the wiring board 300 in a direction of the first through third cell positions S1' through S3'may be electrically connected to another array of photoelectric cells (not shown), or a terminal (not shown) for providing electric power to an external circuit.

Since the conductive patterns 350 of the wiring board 300 overlap the first and second electrodes 121 and 122 of the first through third photoelectric cells S1 through S3, a valid electrode thickness of the first and second electrodes 121 and 122 may be increased and thus series resistance components of the first and second electrodes 121 and 122 may be reduced. Since the first and second electrodes 121 and 122 form a current path of carrier generated by the semiconductor substrate 100, if the valid electrode thickness is increased, a series resistance of the current path may be reduced and a photoelectric efficiency may be increased. However, the conductive patterns 350 are not limited to the above-described shape, arrangement, and number, and may be variously modified.

Meanwhile, alignment units 360 for aligning the first through third photoelectric cells S1 through S3 may be formed on the wiring board 300. For example, the alignment units 360 may utilize relative alignment between the conductive patterns 350 and the first through third photoelectric cells S1 through S3, and may define correct assembling positions.

The alignment units 360 may be formed as alignment marks not only on the wiring board 300 and but also on the first through third photoelectric cells S1 through S3, and the alignment marks may be formed at corresponding corners of the wiring board 300 and the first through third photoelectric cells S1 through S3.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A photovoltaic device comprising:
a substrate;
a first and a second electrode; and
an insulation layer that insulates the electrodes, wherein the device only contains a single insulation layer, wherein the insulation layer comprises via holes which each contain an electrode and the electrode protrudes from a surface of the insulation layer that is furthest away from the substrate.

2. The photovoltaic device of claim 1 further comprising a passivation layer formed between the substrate and the single insulation layer.

3. The photovoltaic device of claim 1 or claim 2, wherein the electrodes each comprise a seed layer, wherein the seed layer is equal to or less thick than the single insulation layer.

4. The photovoltaic device of any of claims 1 to 3, wherein the electrodes each comprise a seed layer, wherein a surface of the seed layer that is furthest away from the substrate is lower than the surface of the single insulation layer that is furthest away from the substrate.

5. The photovoltaic device of any of claims 1 to 4, wherein the electrodes also comprise a conductive connective layer and, optionally the combined thicknesses of the seed layer (d1) and of the conductive layer are greater than by a value t3 of the thickness of single insulation layer and the passivation layer, if present.

6. The photovoltaic device of claim 5, wherein the d1 is between 40% and 60% of the thickness of the single insulation layer (t2).

7. The photovoltaic device of any of claims 1 to 6, wherein the insulation layer has a thickness of between 10µm and 30µm.

8. The photovoltaic device of any of claims 5 to 7, wherein the conductive layer comprises first and second portions of differing widths.

9. The photovoltaic device of claim 8, wherein the first portion is formed on the seed layer and is narrower in width than the second portion.

10. The photovoltaic device of claims 8 or 9, wherein the first portion is of depth d2 and the second portion is of depth t3.

11. The photovoltaic device of any of claims 2 to 10, wherein the passivation layer and the insulation layer comprise different materials, optionally wherein the insulation layer comprises a thermosetting resin.

12. The photovoltaic device of any of claims 2 to 11, wherein the passivation layer comprises a silicon nitride, a silicon oxide or a combination thereof.

13. The photovoltaic device of any of claims 5 to 12, wherein the conductive connection layer is made of a solder material.

14. The photovoltaic device of any of claims 1 to 13, wherein the device comprises an array of photoelectric cells and the device further comprises a wiring board wherein the array of photoelectric cells are conductively connected by the wiring board.

15. A process for producing the photovoltaic device of any claims 1 to 13 comprising the steps of:
forming a single insulation layer comprising via holes on a substrate,
forming electrodes in said via holes.

16. The process as claimed in claim 15, wherein the electrodes are formed by first forming a seed layer in the via holes.

17. The process as claimed in claim 16, wherein a conductive connective layer is formed on the seed layer and the conductive connective layer protrudes out of the single insulation layer.
